# EUROPEAN PATENT SPECIFICATION

(11) **EP 4 597 567 B1**
(45) Date of publication and mention of the grant of the patent: **18.11.2026**
(21) Application number: 25155107.3
(22) Date of filing: 30.01.2025
(51) Int. Cl.: H10W 40/25, H10W 40/73, H10W 40/00, H10W 40/22, H10W 40/60

(54) **CHIP PACKAGE SYSTEM HAVING A VAPOR CHAMBER WITH SOLDER THERMAL INTERFACE MATERIAL AND METHOD OF MANUFACTURING SAME**
CHIPGEHÄUSESYSTEM MIT DAMPFKAMMER MIT LÖTWÄRMESCHNITTSTELLENMATERIAL UND VERFAHREN ZUR HERSTELLUNG DAVON
SYSTÈME DE BOÎTIER DE PUCE AYANT UNE CHAMBRE À VAPEUR AVEC UN MATÉRIAU D'INTERFACE THERMIQUE DE SOUDURE ET SON PROCÉDÉ DE FABRICATION

(30) Priority: 30.01.2024 US 202463626738 P; 24.01.2025 US 202519036771
(43) Date of publication of application: 06.08.2025
(73) Proprietor: Google LLC, Mountain View, CA 94043 (US)
(72) Inventor: Khaire, Vivek B, Mountain View, CA 94043 (US); Samadiani, Emad, Mountain View, CA 94043 (US)
(74) Representative: Betten & Resch

(56) References cited:
- US-A1- 2011 024 892
- US-A1- 2021 013 115
- US-A1- 2022 102 234

## Description

### CROSS-REFERENCE TO RELATED APPLICATIONS

The present application claims the benefit of the filing date of U.S. Provisional Patent Application No. 63/626,738, filed January 30, 2024.

### BACKGROUND

Semiconductor devices ranging from very low power (milli-Watts) to very high power (kilo-Watts) devices generate significant heat during use. Low power devices can be found in battery-powered devices such as watches and phones and high power devices can be found in high-compute environments such as data centers. Regardless of whether a semiconductor device is high or low power, semiconductor devices must be kept within their operating temperature range to properly function. The maximum operating temperature is typically around 100 °C, ranging from typically 85 °C to 130 °C. A high-powered device generates significant amounts of heat and requires an efficient cooling system to maintain its temperature within optimal operating range. The cooling system functions to transfer heat from the semiconductor device to another location where it can dissipate or diffuse heat, such as ambient air through the use of a radiator or a fan.

Various cooling solutions and systems exist to cool semiconductor devices based on their power output, system application, usage environment, and the like. A common solution is to attach a vapor chamber or heat sink made of high thermally conductive material such as copper, on top of the semiconductor chip. The vapor chamber and heat sink are also designed to have a large and extended surface area so that a large hot surface area can be exposed to ambient air.

Document US 2011/0024892 A1 refers to a flip chip microelectronic package having a heat spreader. The microelectronic package comprises a die having a first surface and a second surface, the first Surface being coupled to a substrate; a thermal interface material disposed in thermal conductive contact with the second surface of the die; and a heat spreader adapted for dissipating heat from the die, the heat spreader disposed in thermal conductive contact with the thermal interface material.

Document US 2021/0013115 A1 refers to a microelectronic package comprising an integrated heat spreader (IHS) coupled with a package substrate.

Document US 2022/0102234 A1 refers to an integrated circuit (IC) package comprising a die having a front side and a back side . A solder thermal interface mater (STIM) comprising a first metal is over the backside.

### BRIEF SUMMARY

The present invention is set out in the independent claims. Preferred embodiments are defined by the dependent claims.

An improved chip package system and method of manufacturing the system are disclosed. The chip package system incorporates a vapor chamber that is soldered to a semiconductor chip through use of a solder thermal interface material. This is made possible by soldering a vapor chamber or a portion of the vapor chamber directly to the chip package prior to creating a vacuum in the vapor chamber and hermetically sealing the vapor chamber. Further, providing the vapor chamber to customers without first creating a vacuum within the vapor chamber and/or hermetically sealing the vapor chamber provides these customers, such as contract manufacturers who are responsible for building the chip package system, with greater flexibility to adopt procedures that allow for the vapor chamber to be soldered to a semiconductor chip or device and incorporated into the overall chip package system.

In another aspect, structural and individual components of a cooling system and particularly the vapor chamber may be manufactured by a first vendor or first manufacturer, such as a heat sink manufacturer, with a business location at a first geographic location, but fully assembled with a hermetic seal by a second vendor or second manufacturer, such as a contract manufacturer, with a business location at a different geographic location. This can also provide the second vendor or manufacturer with an ability to adopt procedures to allow for the soldering of the vapor chamber to the semiconductor chip or device and incorporation into the overall chip package system.

According to an aspect of the disclosure, a method of manufacturing a chip package system that has at least one semiconductor chip overlying and attached to a substrate is disclosed. The method includes soldering a first portion of a vapor chamber to the at least one semiconductor chip using a solder thermal interface material; attaching or joining a second portion of the vapor chamber to the first portion to create an enclosed interior chamber within the vapor chamber; introducing a fluid into the interior chamber; and creating a vacuum within the interior chamber of the vapor chamber, wherein the soldering the first portion occurs prior to creating the vacuum.

According to another aspect, a method of manufacturing a chip package system having at least one semiconductor chip overlying and attached to a substrate is disclosed. The method includes soldering a vapor chamber to the at least one semiconductor chip using a solder thermal interface material, the vapor chamber having an enclosed interior chamber within the vapor chamber; introducing a fluid into the interior chamber while the interior chamber is at atmospheric pressure; and creating a vacuum within the interior chamber of the vapor chamber by changing an interior pressure of the interior chamber from atmospheric pressure to less than atmospheric pressure, wherein the soldering occurs prior to creating the vacuum.

According to another aspect of the disclosure, an in-process unit for a chip package system includes a substrate; a semiconductor chip bonded to the substrate; and a portion of a vapor chamber soldered to and in thermal communication with the semiconductor chip. A solder joint may be formed between the vapor chamber and the semiconductor chip and the solder joint may comprise a solder thermal interface material.

### BRIEF DESCRIPTION OF THE DRAWINGS

FIG. 1 depicts an example microelectronic package system according to an aspect of the disclosure.
FIG. 2 depicts components of the microelectronic package system of FIG. 1.
FIGS. 3A-3G depict a method of assembling the microelectronic package system of FIG. 1.
FIG. 4 depicts an example microelectronic package system according to an aspect of the disclosure.
FIGS. 5A-5F depict a method of assembling the microelectronic package system of FIG. 4.
FIG. 6 depicts an example microelectronic package system according to an aspect of the disclosure.
FIGS. 7A-7F depict a method of assembling the microelectronic package system of FIG. 6.
FIG. 8 depicts an example microelectronic package system out of the scope but useful to understand the disclosure.
FIGS. 9A-9D depict a method of assembling the microelectronic package system of FIG. 8.

### DETAILED DESCRIPTION

An improved chip package system and a method of manufacturing the system are disclosed. The chip package system incorporates a vapor chamber heat sink (hereafter "vapor chamber") that is soldered to a semiconductor chip using a solder thermal interface material. Methods of manufacturing the chip package system disclosed herein make it possible to achieve soldering of the vapor chamber at high temperatures. Traditionally, heat sink manufacturers assemble a hermetically sealed vapor chamber and ship it to a contract manufacturer for implementation within a chip package assembly. This procedure places limitations on how the vapor chamber is coupled to the assembly. When incorporating the sealed vapor chamber into a particular system at the contact manufacturer, the sealed vapor chamber is typically attached to the semiconductor chip using a grease or phase change material. These and other similar thermal interface materials, however, contribute to as much as 30-40%, if not more, of the total thermal resistance for chip cooling and possess an average impedance of approximately 16.7 °Cmm²/W. Existing chip package systems with vapor chambers have been unable to incorporate more effective thermal interface materials that have high melting point temperatures. This is because the internal pressure of the sealed vapor chamber increases as temperatures are increased to allow for melting and bonding of the thermal interface material. The increased temperature results in deformation of the vapor chamber, which is detrimental to vapor chamber performance.

A chip package system is disclosed that allows for a vapor chamber to be soldered to a semiconductor chip through use of a solder thermal interface material with a high melting point. This is made possible by soldering a vapor chamber or a portion of the vapor chamber directly to the chip package prior to creating a vacuum in the vapor chamber and hermetically sealing the vapor chamber. In some examples, the melting point of such thermal interface materials may be greater than at least 120°C, but in other examples the melting point may be equal to or below this amount. In still other examples, the melting point may be higher than at least 150 °C, or higher than at least 200 °C, or higher than at least 250 °C, or higher than at least 300 °C, or higher than at least 500 °C. But, in other examples, the melting point may be less than these amounts, and less than 120 °C.

In another aspect, structural and individual components of a cooling system and particularly the vapor chamber may be manufactured by a heat sink manufacturer with a business location at a first geographic location, but fully assembled with a hermetic seal by a contract manufacturer having a business location at a different geographic location. This process allows for more flexibility in the manufacture and assembly of a completed chip package assembly.

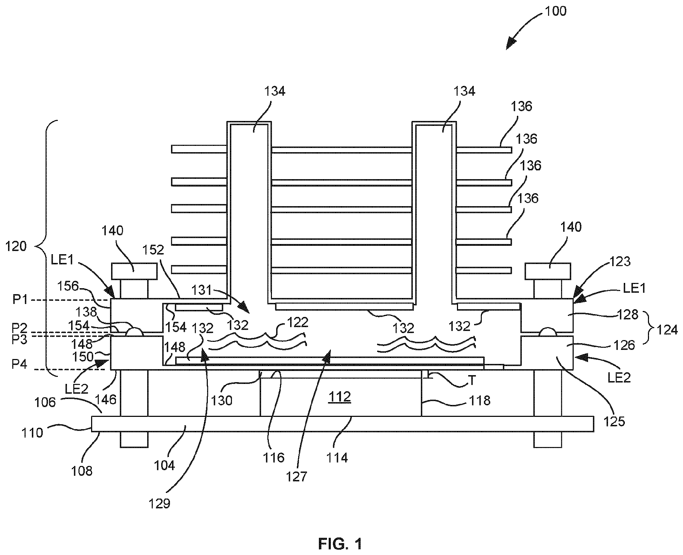

FIG. 1 depicts a semiconductor chip package system 100 that includes a substrate 104, a microelectronic element, such as semiconductor chip 112, and cooling system 120. Cooling system 120 can further include a vapor chamber 124 and thermal fins 136 attached to vapor chamber 124. Vapor chamber 124 can optionally include heat pipes 134 to further enhance heat dissipation. In this example, vapor chamber 124 includes at least two distinct parts: a first lower portion 126 and a second upper portion 128. Lower portion 126 and upper portion 128 may be coupled or joined together to form a completed vapor chamber 124 having an outer housing 125, which in this example is accomplished by mechanically and hermetically sealing lower portion 126 and upper portion 128 together. Gasket 138 may further help to maintain the vacuum seal and mechanical fasteners, such as screws 140, may extend through vapor chamber 124 to secure lower and upper portions 126, 128 together and to attach vapor chamber 124 to substrate 104. Vapor chamber 124 is also bonded to chip 112 by soldering vapor chamber 124 to chip 112 with a solder thermal interface material ("STIM") 130 that has high thermal conductivity to assist in the transfer of heat from chip 112 to vapor chamber 124. As will be discussed in more detail, methods for assembling vapor chamber 124 and overall cooling system 120 described herein make it possible to implement STIMs having high thermal conductivity and requiring high temperatures to accomplish melting, without deforming, or with only minimal deformation of, vapor chamber 124. Use of STIMs may further require the use of flux to accomplish soldering.

Attaching or joining upper portion 128 to lower portion 126 creates an interior chamber 127 defined by an open space within the interior of vapor chamber 124. Lower and upper portions 126, 128 may be plates comprised of thermally conductive metal materials, that may include without limitation, copper, titanium, or the like.

In one example, the main body 123 of upper portion 128 of vapor chamber 124 may include a u-shaped profile and may include top surface 152, bottom surface 154, and an edge surface 156 that extends between top and bottom surfaces 152, 154. Outermost lateral ends LE1 may extend along a first plane P1 that extends along top surface 152 of upper portion 128 and that is parallel to a second plane P2 that extends along a bottom surface 154 of upper portion 128. An upper recess portion 131 is formed between outermost lateral ends LE1 of upper portion 128 and in a space between first plane P1 and second plane P2.

Lower portion 126 of vapor chamber 124 may also have a u-shaped profile. Lower portion 126 of vapor chamber 124 includes top surface 148, bottom surface 146 and edge surface 150 that extends between top and bottom surfaces 148, 146. Outermost lateral ends LE2 may extend along a third plane P3 that extends along top surface 148 of lower portion 126 and that is parallel to a fourth plane P4 that extends along bottom surface 146 of lower portion 126. A lower recess 129 is formed between outermost lateral ends LE2 of lower portion 126 and in a space between third plane P3 and fourth plane P4.

Interior chamber 127 may be formed in the space between interior bottom surface 154 of upper portion 128 and interior top surface 148 of lower portion 126. Heat transfer fluid 122 may be provided within interior chamber 127, such as, water, refrigerant, or other known vapor chamber fluids that can reach a boiling point in response to heat being received. In this example, vapor chamber 124 includes only one interior chamber 127 within housing 125, but in other examples, additional chambers can be created. Interior chamber 127 may optionally include a wicking material or other features to enhance condensation to allow for better heat transfer of fluid 122 to heat pipes 134 and fins 136. In some examples, wicking material may be a porous material or component used to enhance circulation of fluid once the vapor chamber is formed so as to circulate and spread heat. Capillary action of the wicking material can further facilitate movement of heat from within the chamber. Wicking material can be provided on any desired surface of interior chamber 127, For example, wicking material 132 is schematically shown lining top surface 148 of lower portion 126 and bottom surface 154 of upper portion 128, but wicking material 132 may instead be elongated filaments that line top surface 148 and bottom surface 154, or any other structure or material. Wicking material can include sintered, grooved, and mesh fiber wicks. In other example, a wicking material may be limited to only top surface 148 or bottom surface 154 or one or both edge surfaces that extend between top and bottom surfaces 148, 154.

STIM 130 may be used to bond vapor chamber 124 to chip 112 and may have a high thermal conductivity and a higher melting point temperature than materials commonly used to bond vapor chambers to semiconductor chips. Vapor chamber deformation often occurs near and above 100 °C. The selected STIM may have a melting point ranging from 110 °C to 200 °C, or a range of 110 °C to 180 °C, or a range of 110 °C to 150 °C, or a range of 160 °C to 180 °C, or other subsets of ranges between 110 °C and 200 °C. In other examples, STIM 130 may have a melting point less than 110 °C, or less than 120 °C, or less than 180 °C. And in other examples, STIM 130 may have a melting point greater than 110 °C or greater than 180 °C. For example, the selected STIM may have a melting point of 160 °C.

STIM 130 may have a thermal conductivity ("K") measured in watts per meter-Kelvin ("W/mK") ranging between about 15 W/mK and 100 W/mk, such as 18 W/mK. In other examples, thermal conductivity ("K") may range between 15 W/mK and about 30 W/mK, such as about 20 W/mK, for example. In other examples, STIM 130 may have a thermal conductivity ("K") ranging from 30 W/mK to 100 W/mK. In still other examples, thermal conductivity may be greater than 30 W/mK; or thermal conductivity may be greater than 15 W/mK; or a thermal conductivity greater than 50 W/mK.

In one example, STIM 130 may be a sheet or foil comprised of indium. The indium may be comprised of pure indium or an indium alloy. Indium possesses desirable characteristics to decrease thermal resistance. For example, indium possesses a bulk thermal resistance of approximately 7 °Cmm²/W and thermal conductivity of 86 W/mK, as well as a higher melting point of 156.6 °C. Indium therefore possesses significantly greater thermally conductive features than commonly used thermal interface materials. For example, commonly used thermal grease or phase change materials have a thermal impedance of approximately 16.7 °Cmm²/W and a thermal conductivity of only 5 W/mK. Thus, use of indium, as well as other thermal interface materials with similar characteristics to attach vapor chamber 124 to semiconductor chip 112, can improve thermal dissipation of heat from semiconductor chips and allow for an increased reduction of impedance. In some examples, impedance can be reduced by approximately 50% through use of indium. Examples of suitable materials for STIM 130 may include, without limitation, pure indium, indium alloys such as 90In10Ag and 97In3Ag, or any metal-based alloy having indium, tin, silver, gold, gallium, or any other known high thermally conductive metal. Thus, according to the methods and structure disclosed herein, it is possible to select and use thermally conductive materials with higher melting points and higher thermal conductivity to form a bond between the vapor chamber 124 and semiconductor chip 112 than traditionally available due to deformation of the vapor chamber at high temperatures or temperatures approaching 100 °C and greater.

STIM 130 may be formed to a thickness T that can range between about 40 µm and about 400 µm. In some examples, thickness T may be 100 µm or 200 µm. In other examples, thickness T may be less than 40 µm or greater than 400 µm. In some applications, it may be desired to further use a flux material with STIM 130 when soldering vapor chamber 124 to chip 112.

Focusing on the other components of chip package system 100, substrate 104 includes top surface 106, bottom surface 108, and edge surface 110 that extends between top and bottom surfaces 106, 108 and defines a thickness T of substrate 104. Substrate 104 may be a printed circuit board, a dielectric with circuitry, or other carrier that support a microelectronic element, such as a semiconductor chip or device. Semiconductor chip 112 includes an active surface 114, a rear surface 116, and edge surface 118 that extends between active and rear surfaces 114, 116. Semiconductor chip 112 can be comprised of any chip type, such as memory chips or high speed processor chips that generate significant heat.

In use, chip 112 generates heat, which is transferred through STIM 130 to vapor chamber 124. Heat may then be further transferred into fluid 122, which may boil or vaporize. The boiling or vaporized fluid 122 circulates toward a top of the vapor chamber 124 and, in this example, vaporized fluid and heat are transferred into the heat pipes 134 of vapor chamber 124, as well as through thermal fins 136 that are attached to vapor chamber 124. Wicking material 132 within vapor chamber 124 may further assist with the overall process of heat transfer. As heat is transferred, vaporized fluid 122 will condense back into liquid form and fall back to vapor chamber 124 to allow for a continuous cycle of heating, vaporizing, and condensing.

According to at least one example method of assembling a chip package system that includes a cooling system, structural components of cooling system 120 and particularly components of vapor chamber 124 may be manufactured by a heat sink manufacturer having a place of business at a first geographic location, but fully assembled and hermetically sealed by a contract manufacturer located at a different geographic location. This method allows for implementation of STIMs within the package assembly, without deforming or with only minimal deformation of vapor chamber 124. Such STIMs further improve thermal conductivity over traditional thermal interface materials, such as grease and phase change material.

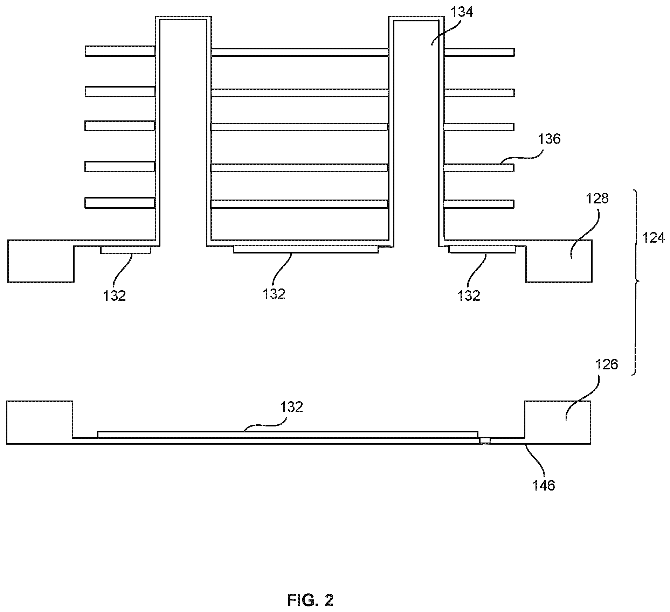

FIG. 2 illustrates components of vapor chamber assembly 124 of FIG. 1. In one example, vapor chamber assembly 124 can be manufactured by a first vendor, including, without limitation, a heat sink manufacturer at a business location at a first geographic location. As shown, vapor chamber 124 can include a lower portion 126 and an upper portion 128 with optional heat pipes 134. Wicking material 132 may be included and be formed as part of upper and lower portions 126, 128 of vapor chamber 124. Fins 136 may also be manufactured at and/or purchased by the first vendor and in this example may be attached to vapor chamber 124 and particularly heat pipes 134. The first vendor may ship out these components of vapor chamber 124 to a second vendor, such as a contract manufacturer who can incorporate vapor chamber 124 into an overall chip package system, at a second business location in a different geographic location. The first vendor may pre-attach fins 136 to vapor chamber 124 prior to shipping them to the second vendor or the first vendor may separately ship fins 136 to the second vendor, who can instead assemble and attach fins 136 to vapor chamber 124. In other examples, other fins may be manufactured by a different first vendor or fins may be omitted from the cooling system altogether and will not be included in the final chip package system. Although reference is made to a vendor, it is to be appreciated, that the vendor can be any company, manufacturer, or entity that is involved in the manufacture and/or distribution and/or assembly of one or more components of the overall system.

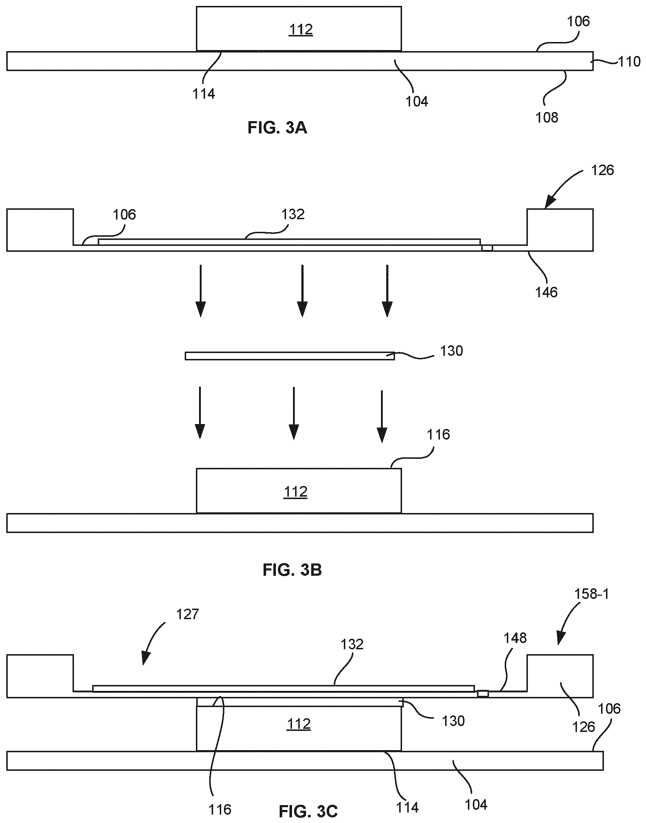

FIGS. 3A-3G illustrate one example method of manufacturing chip package system 100 shown in FIG. 1 that incorporates multi-piece vapor chamber 124. In one example, chip package system 100 can be manufactured and assembled by the second vendor or contract manufacturer who received some or all of the cooling system components, including vapor chamber components from the first vendor. FIG. 3A illustrates chip 112 attached to substrate 104. Substrate 104 includes a top surface 106, bottom surface 108 and edge surface 110. In this example, active surface 114 of chip 112 may face toward and be conductively bonded to top surface 106 of substrate 104 using conductive elements, such as solder balls or the like, which are omitted for ease of discussion. An optional interposer or other intermediate substrate may also be incorporated to provide an interconnection between substrate 104 and microelectronic element 112.

A portion of vapor chamber assembly 124 may be attached to semiconductor chip 112, as shown in FIG. 3B. In one example, lower portion 126 of vapor chamber 124 is attached to semiconductor chip 112. Bottom surface 146 of lower portion 126 can be soldered to rear surface 116 of chip 112 using STIM 130. As noted above, STIM 130 may have a high thermal conductivity and a melting point temperature of 120 °C / 84 W/mK or greater to achieve melting of STIM 130. But, in other applications, it may be desired to have a melting point temperature below 120 °C. STIM 130 in this example may be a conductive Indium foil, but other materials and forms of material can be implemented. During soldering, a flux material may be utilized with Indium foil to achieve a solder connection or solder joint between bottom surface 146 of lower portion 126 and chip 112. Wicking material can be provided along any surface of lower portion 126. In this example, wicking material 132 is provided along top surface 106 of lower portion 126. Wicking material 132 can take on a variety of configurations and may be placed along any portions of lower portion 126.

Once lower portion 126 is attached to semiconductor chip 112, in-process unit 158-1 is created, as shown in FIG. 3C, which is a subassembly of the overall chip package system 100. In-process unit 158-1 can include substrate 104, chip 112 attached to substrate 104, and lower portion 126 of vapor chamber 124 attached to chip 112 with STIM 130. In this arrangement, lower portion 126 may be bonded or soldered to rear surface 116 of chip 112 using STIM 130 so that top surface 148 of lower portion 126 and wicking material 132 are exposed and face in a direction away from top surface 106 of substrate 104 and front surface 114 of chip 112. Recess 131 of lower portion 126 will also be exposed in this configuration.

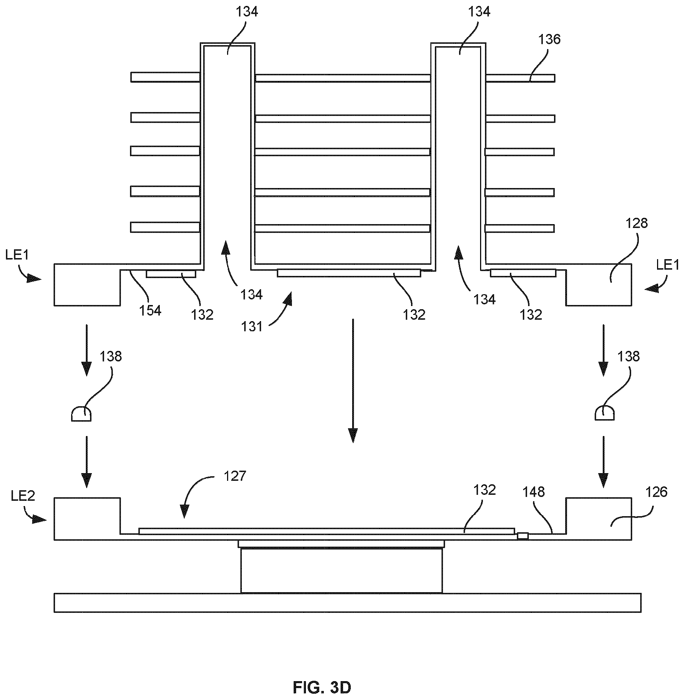

Upper portion 128 of vapor chamber 124 may be joined to lower portion 126 of vapor chamber 124, as shown in FIG. 3D. In this configuration, bottom surface 154, wicking material 132 disposed at bottom surface 154 of upper portion 128, and recess 131 of upper portion 128 may be exposed and face toward respective top surface 148, wicking material 132 disposed at top surface 148, and recess 131 of lower portion 126. Upper portion 128 further includes lateral ends LE1 that are spaced apart by bottom surface 154 of upper portion. Fins 136 may also be attached to upper potion 128 prior to the joining of upper portion 128 to lower portion 126, but in other examples, fins 136 may be attached to upper portion 128 at a later stage in the process. Lower portion 126 includes lateral ends LE2 that are spaced apart by top surface 148 of lower portion 126. Heat pipes 134 may extend upwardly and be connected to recess 131 of lower portion 126, which can help to transfer heat away from vapor chamber 124. In some examples, heat pipes may be metal pipes made from copper, aluminum, or other metals with high thermal conductivity. During assembly, gasket 138 may be disposed between lower portion 126 and upper portion 128 to later help form a vacuum or hermetic seal. Gasket 138 can be an O-ring or other structure to seal the gap between the lower and upper portions 126, 128. Gasket 138 may be comprised of rubber or any other suitable material able to maintain hermetic sealing, and can be sized as needed to fill the gap between lower and upper portions 126, 128.

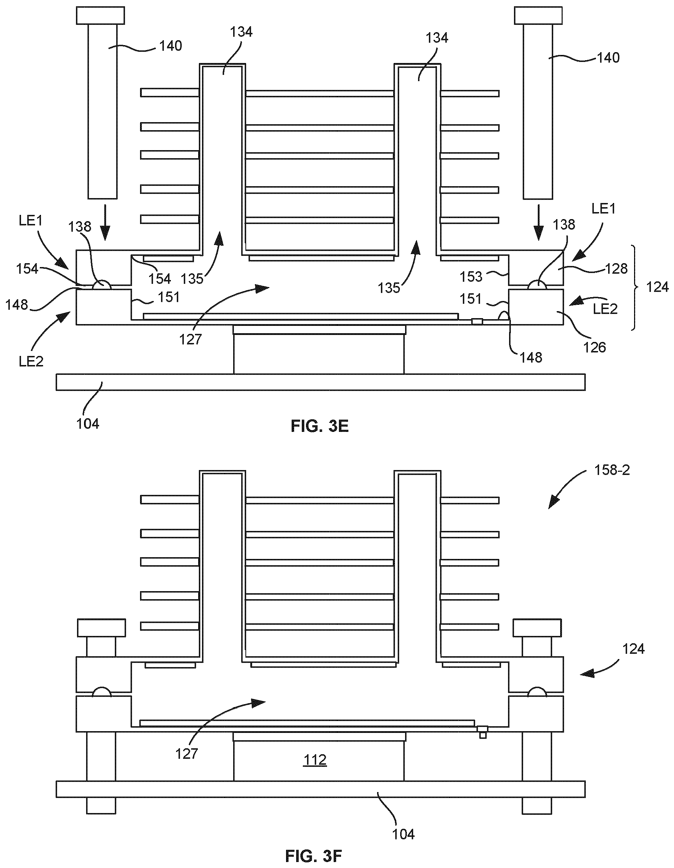

As shown in FIG. 3E, upper portion 128 and lower portion 126 may be mechanically coupled together to form the fully assembled vapor chamber 124. In this example, any type of mechanical fasteners, such as screws 140, rivets, springs (not shown), and the like may be used to secure lower and upper portions 126, 128 together, as well as to secure the completed vapor chamber 124 to substrate 104. Once lower and upper portions 126, 128 are joined together, gasket 138 is disposed between lateral ends LE1 of upper portion 128 and lateral ends LE2 of lower portion 126, and particularly between top surface 148 of lower portion 126 and bottom surface 154 of upper portion 128. Interior chamber 127 may be formed by joinder of lower and upper portions 126, 128 and defined by top surface148 and interior edge surface 151 of lower portion 126 and bottom surface 154 and interior edge surface 153 of upper portion 128. In still other examples, and as will be described herein, non-mechanical fasteners can be used to secure upper and lower portions 126, 128 together, such as bonding upper and lower portions together with a material and/or process that attaches upper and lower portions 126, 128 together.

FIG. 3F illustrates another in-process unit 158-2 that may be formed after vapor chamber 124 has been solder bonded to chip 112 and secured to substrate 104. At this stage, vapor chamber assembly 124 has no fluid within interior chamber 127 and no hermetic seal. Vapor chamber assembly 124 may instead be at atmospheric pressure.

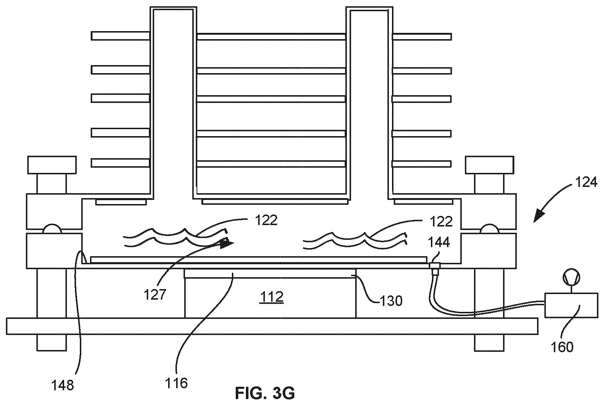

Vapor chamber 124 may be filled with fluid 122 and hermetically sealed after vapor chamber 124 has been attached to chip 112, and in this example, after at least portions of vapor chamber 124 have been solder bonded to chip 112. As shown in FIG. 3G, fluid 122 may be introduced into interior chamber 127 through a port that provides access to interior chamber 127, such as port 144 positioned along surface 148 of vapor chamber 124. Vacuum pump 160 may be further connected to vapor chamber 124 through port 144 to create a vacuum within interior chamber 127 and to assist with hermetical sealing of vapor chamber 124. Once vapor chamber 124 is hermetically sealed, vacuum pump 160 can be removed. By fully assembling and sealing vapor chamber 124 after at least a portion of vapor chamber 124 is first bonded to chip 112, a high temperature STIM 130 may be utilized to create a solder bond between lower portion 126 and rear surface 116 of chip 112. Use of STIM 130 provides for increased thermal conductivity of STIM and can help to reduce thermal resistance by approximately 50%, as compared to use of traditional thermal interface materials, such as grease or phase change material.

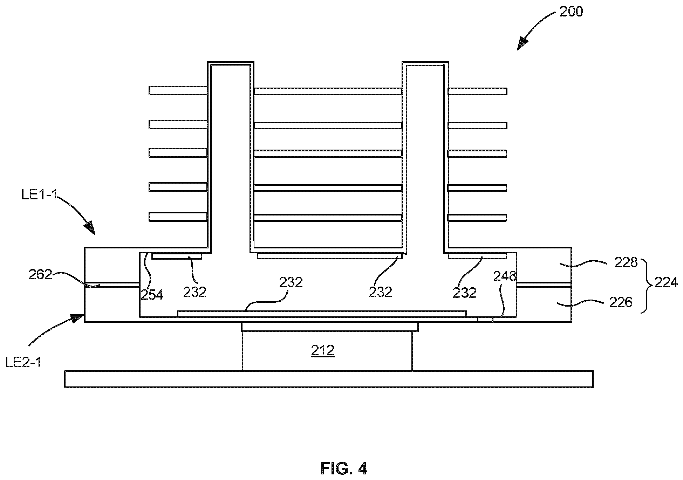

FIG. 4 illustrates another example microelectronic package system 200 that incorporates a vapor chamber 224 having a lower portion 226 and an upper portion 228. The only difference between microelectronic package system 100 and microelectronic package system 200 is that lower portion 226 and upper portion 228 of microelectronic package system 200 may be bonded together by a bonding material 262 instead of a mechanical attachment, such as a screw, spring, and gasket. Bonding material 262 may include a low temperature solder with thermally conductive properties. For example, bonding material 262 may be comprised of low temperature solder having melting points ranging from 47 °C (117 °F) to 160 °C (320 °F) Traditional solder material can include, for example and without limitation, solder alloys containing Tin blended with a variety of metals such as Indium, Bismuth, Cadmium, and the like. As shown, bonding material 262 may be positioned between outer bottom surface 254 of lateral end LE1-1 of upper portion 228 and top surface 248 of lateral end LE2-1 of lower portion 226. As the remaining components of system 200 in this example can be identical to FIG. 1 and similar elements are given similar numbers, a detailed discussion of the features is omitted for ease of discussion.

As in the previous example, lower and upper portions 226, 228 of vapor chamber 224 may be provided by a heat sink manufacturer to a contract manufacturer responsible for manufacturing and assembling chip package system 200. The heat sink manufacturer may provide lower and upper portions 226, 228 as separate components, providing the contract manufacturer with the ability to fully assemble vapor chamber 224 when assembling chip package system 200. As will be further explained below, this can allow for creation of a solder bond between vapor chamber 224 and chip 212, as well as selection of a STIM with high thermally conductivity.

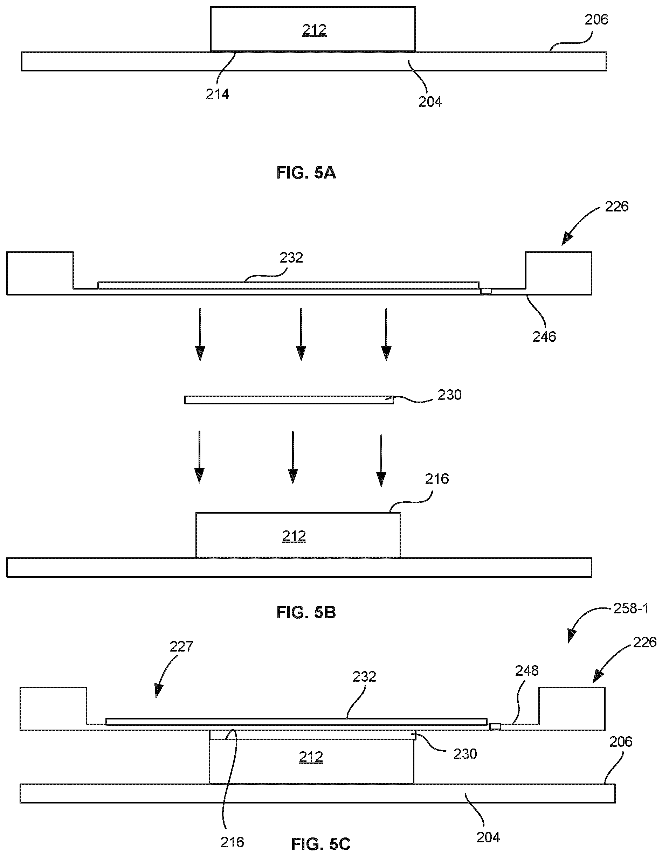

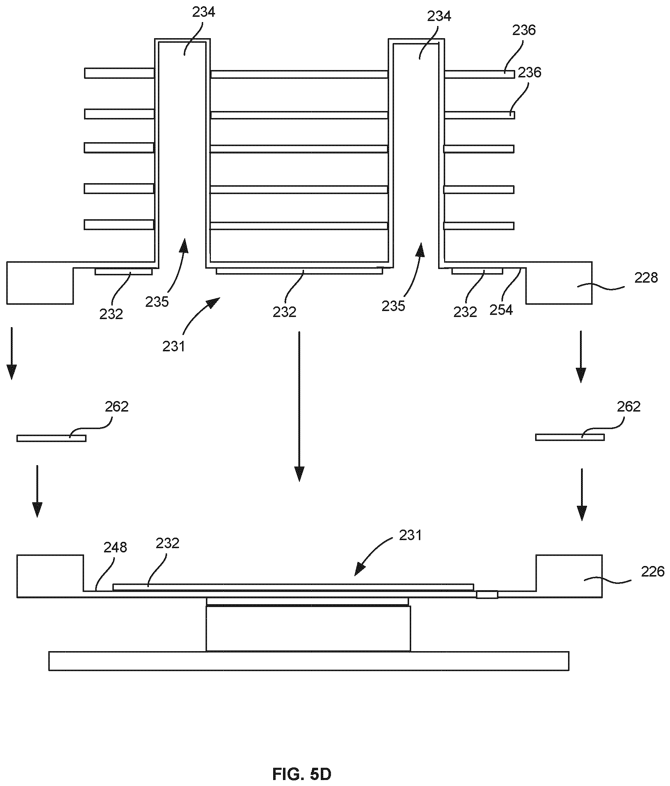

FIGS. 5A-5F illustrate a method for manufacturing chip package system 200. The method of manufacturing illustrated in the subset of FIGS. 5A-5C is identical to FIGS. 3A-3C and similar steps are discussed in FIGS. 5D-5F, and the discussion of FIGS. 3A-3F is equally applicable here, with similar reference elements referring to similar elements. With reference to FIG. 5A, a microelectronic element or semiconductor chip 212 and substrate 204 are provided. Front active surface 214 of microelectronic element 212 may be coupled to top surface 206 of substrate 204. As in the previous example, substrate 204 may be a printed circuit board, a dielectric with circuitry, or other carrier for supporting chip 212. Chip 212 and substrate 204 may be provided at the contract manufacturer where the overall chip package system 200 is fully assembled.

Lower portion 226 of vapor chamber assembly 224 may be attached to rear surface 216 of chip 212 with STIM 230, as shown in FIG. 5B. As in the previous examples, STIM 230 may have a melting point greater than 120 °C and be applied between rear surface 216 of chip 212 and bottom surface 246 of lower portion 226. But, in other examples, the melting point of STIM 230 may be less than 120 °C and in some examples, the melting point of STIM 230 may range from 110 °C to 180 °C. In some examples, STIM 230 may be comprised of Indium, and in still further examples, STIM 230 may be a foil comprised of Indium. In some examples, STIM 230 may first be applied to rear surface 216 of chip 212 and in other examples, STIM 230 may first be applied to bottom surface 246 of lower portion 226. STIM 230 may include at least the properties described above which are not repeated again for brevity and ease of discussion. Bonding only a portion of vapor chamber assembly 224 to chip 212 makes it possible to form a solder bond between vapor chamber assembly 224 and chip 212 without deforming or with minimal deformation of vapor chamber assembly 224.

The resulting structure of lower portion 226 bonded to chip 212 is in-process unit 258-1, as shown in FIG. 5C, which is a subassembly of the overall chip package system 200. In-process unit 258-1 can include substrate 204, chip 212, and lower portion 226. Chip 212 may be coupled or attached to substrate 204. In this example, chip 212 is bonded to substrate 204 using known means, including without limitation, solder bonded with solder balls, solder posts, or any other form of conductive connection between chip 212 and substrate 204. In this arrangement, lower portion 226 can be solder bonded to rear surface 216 of chip 212 with STIM 230 so that top surface 248 of lower portion 226 and wicking material 232are exposed and face in a direction away from top surface 206 of substrate 204 and rear surface 216 of chip 212. Recess 231 of lower portion 226 will also be exposed in this example. Wicking material includes features and the arrangement of wicking material previously described herein,

The attaching or joining of upper portion 228 of vapor chamber 224 to lower portion 226 of vapor chamber 224 is shown in FIG. 5D. In this configuration, bottom surface 254 of upper portion 228, wicking material 232 disposed at bottom surface 254 of upper portion 228, and recess 231 of upper portion 228 may be exposed and face toward respective top surface 248, wicking material 232 disposed at top surface 248, and recess 231 of lower portion 226. Additionally, openings 235 of heat pipes 234 face toward top surface 248 of lower portion 226. Upper portion 228 may be bonded to lower portion 226 using a bonding material 262, which may be, for example, a solder material or other bonding material that can help to secure upper portion 228 and lower portion 226 together and later maintain hermetic pressure within vapor chamber 224. Fins 236 may also be attached to upper portion 228 prior to joining upper portion 228 to lower portion 226, but in other examples, fins 236 may be attached to upper portion 228 at a later stage in the process. In this example, fins 236 may be soldered to heat pipes 234 or include structure that is connected to heat pipes 234.

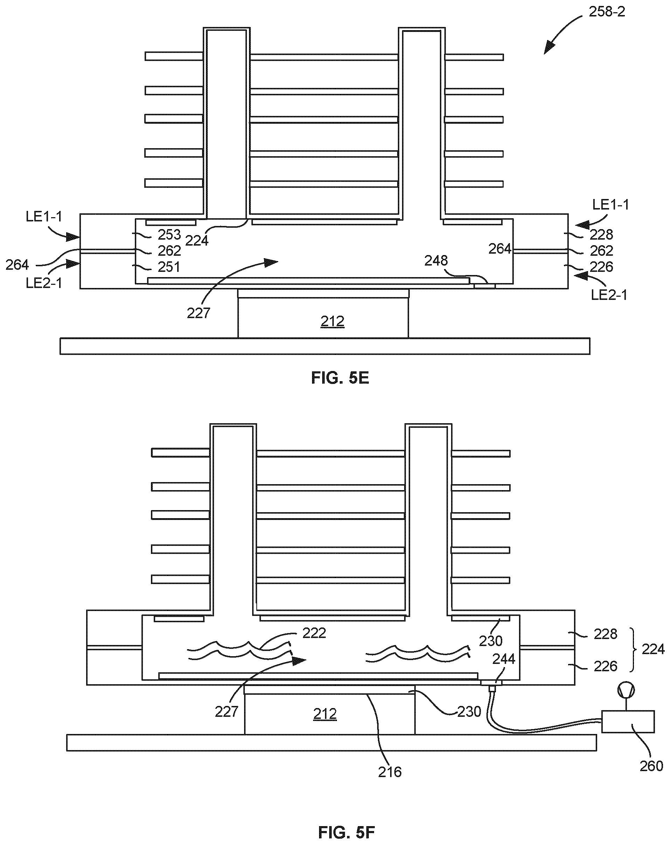

Lower portion 226 and upper portion 228 are shown bonded together in FIG. 5E and the overall structure forms another in-process unit 258-2. Once joined together, bonding material 262 forms a joint 264 between lower portion 226 and upper portion 228, and in this example a solder joint 264 between lateral edges LE1-1 of upper portion 228 and lateral edges LE2-1 of lower portion 226. Interior chamber 227 is also formed and defined by top surface 248 and interior edge surface 251 of lower portion 226 and bottom surface 254 and interior edge surface 253 of upper portion 226. At this stage, vapor chamber assembly 224 has no fluid within interior chamber 227 and vapor chamber 224 is not yet hermetically sealed. Vapor chamber assembly 224 may instead be at atmospheric pressure.

Vapor chamber 224 may be hermetically sealed after vapor chamber 224 has been bonded to chip 212, and in this example, after at least portions of vapor chamber 224 have been solder bonded to chip 212. As shown in FIG. 5F, fluid 222 may be introduced into interior chamber 227 through a port in vapor chamber 224, such as port 244 positioned within lower portion 226. Vacuum pump 260 may be further connected to vapor chamber 224 through port 244 to create a vacuum within interior chamber 227 and to hermetically seal vapor chamber 224. Once vapor chamber 224 is hermetically sealed, vacuum pump 260 can be removed. By fully assembling and sealing vapor chamber 224 after at least a portion of vapor chamber 224 is first bonded to chip 212, a high temperature STIM 230 may be utilized to create a solder bond between lower portion 226 and rear surface 216 of chip 212. As in the previous examples, use of STIM 230 provides for increased thermal conductivity of STIM and can help to reduce thermal resistance, as compared to use of traditional thermal interface materials, such as grease or phase change material. In some examples, the reduction in thermal resistance may be approximately 50%.

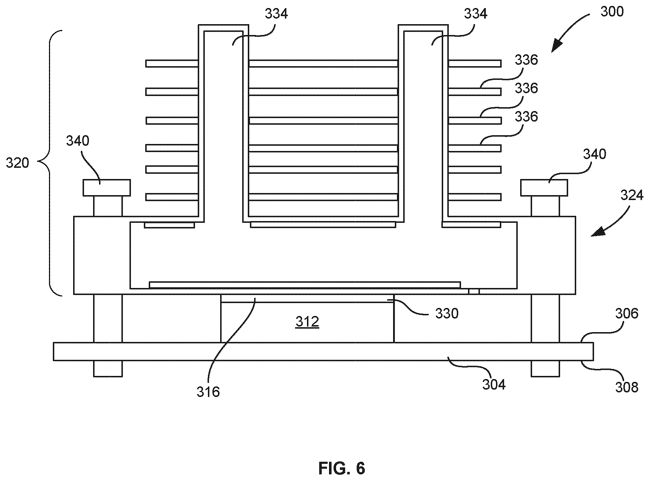

FIG. 6 illustrates another chip package system 300 that includes a cooling system 320. As shown, chip package system 300 is supported by a substrate 304 having a top surface 306 and a bottom surface 308. As in the previous examples, substrate 304 may be a printed circuit board, a dielectric element with circuitry, a carrier, or other structure for supporting chip package system 300. A semiconductor chip 312 may be bonded to substrate 304. Vapor chamber 324 may overlie substrate 304 and chip 312. In this example, vapor chamber 324 is a one-piece structure that may be directly bonded to rear surface 316 of chip 312 and in this example, solder bonded to chip 312 using STIM 330 that has a melting point greater than at least 120 °C and may possess properties identical to STIM 130, 230 previously described herein. In one example, STIM 330 may be comprised of Indium. But, in other examples, the melting point may be less than or equal to 120 °C. Fins 336 may be bonded to heat pipes 334 and may extend in a direction parallel to top surface 306 of substrate 304 and rear surface 316 of chip 312. Vapor chamber 324 may be mechanically secured to substrate 304 through the use of mechanical fasteners, such as screws 340, optional springs, or any other types of fasteners that can secure vapor chamber 324 to substrate 304.

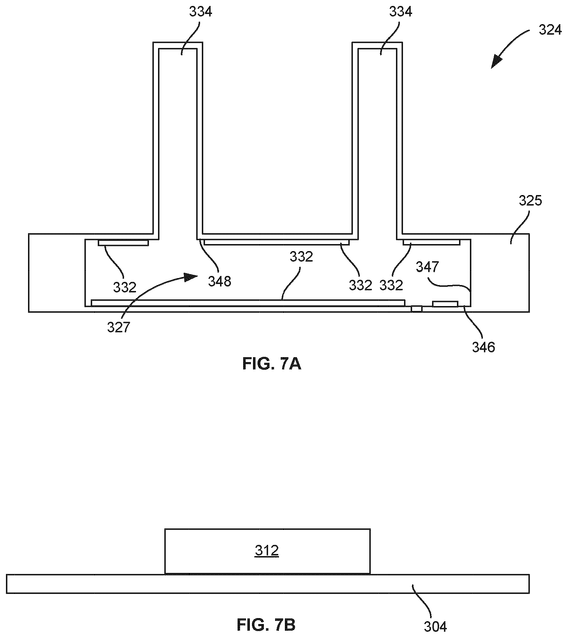

FIGS. 7A-7F illustrate a method of manufacturing chip package system 300. FIG. 7A illustrates an assembled one-piece vapor chamber assembly 324. Vapor chamber assembly 324 is shown at atmospheric pressure, without fluid, and prior to being hermetically sealed. Vapor chamber 324 can include an outer housing 325, an interior chamber 327 having an interior bottom surface 346, an interior top surface 348, and interior edge surfaces 347 extending between the bottom and top surfaces 346, 348. Wicking material 332 may be provided along interior bottom and top surfaces 346, 348. Heat pipes 334 may optionally extend upwardly from interior chamber 327. Vapor chamber 324 is otherwise similar to vapor chambers 124, 224 except that it is a unitary or one-piece structure. Vapor chamber 324 may be assembled and provided in this form, without fluid and without a hermetical seal, by a heat sink manufacturer and shipped to a contract manufacturer that will fully assembly chip package system 300. In this example, conductive fins are not yet attached to vapor chamber 324, but in other examples, fins 336 may already be attached to vapor chamber 324 when the heat sink manufacturer provides vapor chamber 324 to the contract manufacturer.

FIG. 7B illustrates a semiconductor chip 312 that is attached to substrate 304. Semiconductor chip 312 and substrate 304 are similar to chips 112, 212 and substrates 104, 204 previously described herein and are not further discussed for brevity and ease of discussion. A contract manufacturer may attach semiconductor chip 312 to substrate 304, or the substrate 304 and attached semiconductor chip 312 may be provided by a third party.

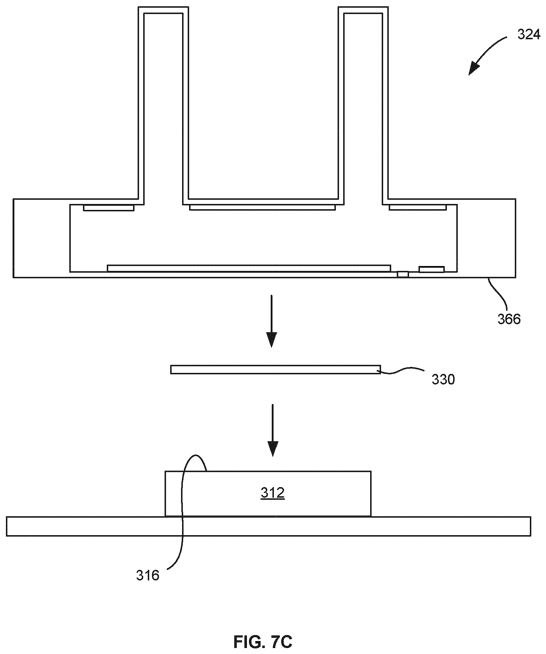

Vapor chamber 324 (without fluid and without a hermetic seal) may be bonded to chip 312. Bottom surface 366 of vapor chamber 324 may be bonded to rear surface 316 of chip 312, as shown in FIG. 7C. STIM 330, as previously described herein, may be provided between bottom surface 366 of vapor chamber 324 and rear surface 316 of chip 312. Additional flux may also be provided, if needed. Vapor chamber 324 may be soldered to chip 312 using STIM 330 so that a solder bond or joint is formed between vapor chamber 324 and chip 312.

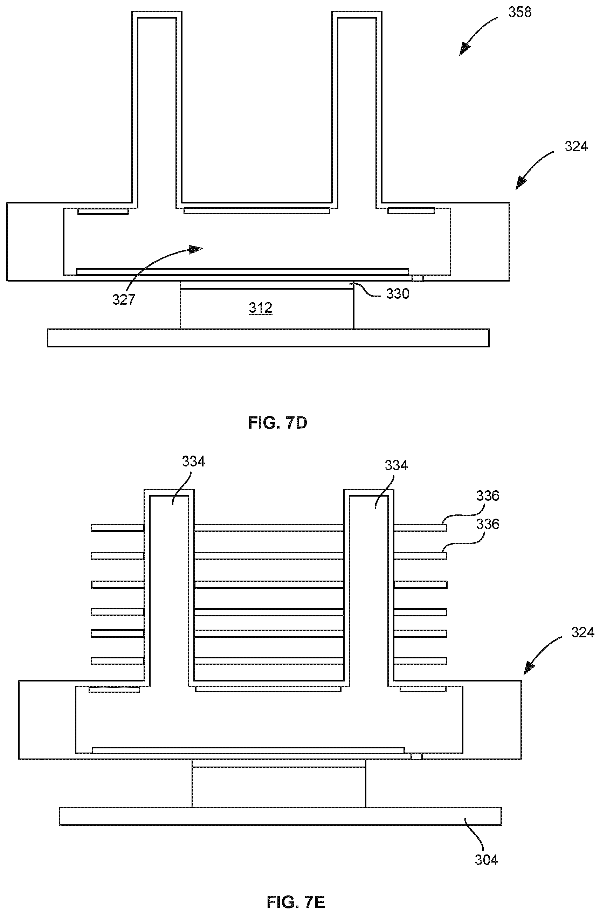

FIG. 7D illustrates in-process unit 358 that results from solder bonding vapor chamber 324 to chip 312 using STIM 330. At this stage, interior chamber 327 contains no fluid and is not hermetically sealed. Vapor chamber 324 may instead be at atmospheric pressure.

Fins 336 may be attached to vapor chamber 324, as shown in FIG. 7E. As shown, fins 336 may overlie top surface of vapor chamber 324 and substrate 304. Fins may be soldered to heat pipes 334 of vapor chamber 324.

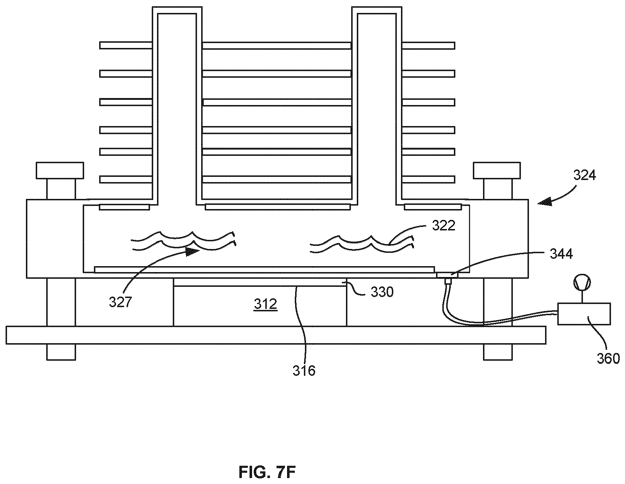

Vapor chamber 324 may be hermetically sealed after vapor chamber 324 has been bonded to chip 312, and in this example, after at least portions of vapor chamber 324 have been solder bonded to chip 312. As shown in FIG. 7F, fluid 322 may be introduced into interior chamber 327 through a port that provides access to interior chamber 327, such as port 344 positioned along the bottom surface of vapor chamber 324. Vacuum pump 360 may be further connected to vapor chamber 324 through port 344 to create a vacuum within interior chamber 327 and to hermetically seal vapor chamber 324. Once vapor chamber 324 is hermetically sealed, vacuum pump 360 can be removed. By fully assembling and sealing vapor chamber 324 after at least a portion of vapor chamber 324 is first bonded to chip 312, a high temperature STIM 330 may be utilized in chip package system to create a solder bond between lower portion 326 of vapor chamber 324 and rear surface 316 of chip 312. Use of STIM 330 provides for increased thermal conductivity of STIM and can help to reduce thermal resistance, as compared to use of traditional grease or phase change material. In some examples, the reduction in thermal resistance may be approximately 50%.

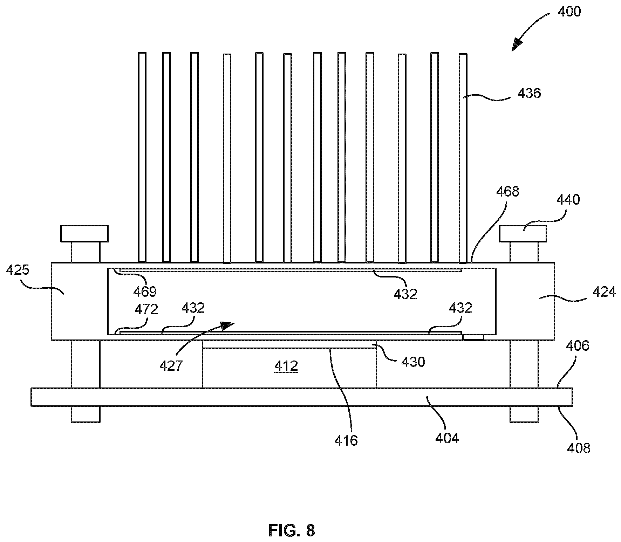

FIG. 8 illustrates another chip package system 400. In this example, vapor chamber 424 is again bonded to rear surface 416 of semiconductor chip 412 by a bonding material, which in this example may be a STIM 430, and which may possess properties similar to STIMs 130, 230, 330 previously described herein. Vapor chamber 424 includes an interior chamber 427 with wicking material 432 provided along interior top surface 469 and bottom interior surface 472 of interior chamber 427. Vapor chamber 424 differs from previous examples to the extent vapor chamber 424 is a two-dimensional vapor chamber since it does not additionally incorporate heat pipes. In another examples, vapor chamber 424 could also be comprised of at least two portions, such as an upper portion and lower portion as previously discussed herein. Fins 436 are shown attached to top surface 470 of vapor chamber 424 and extend vertically in an upward direction away from top surface 470 of vapor chamber 424. Vapor chamber 424 may be further attached to substrate 404 through mechanical fasteners, such as screws 440 that extend through outer housing 425 of vapor chamber 424 and through top surface 406 and bottom surface 408 of substrate 404, and optionally springs (not shown).

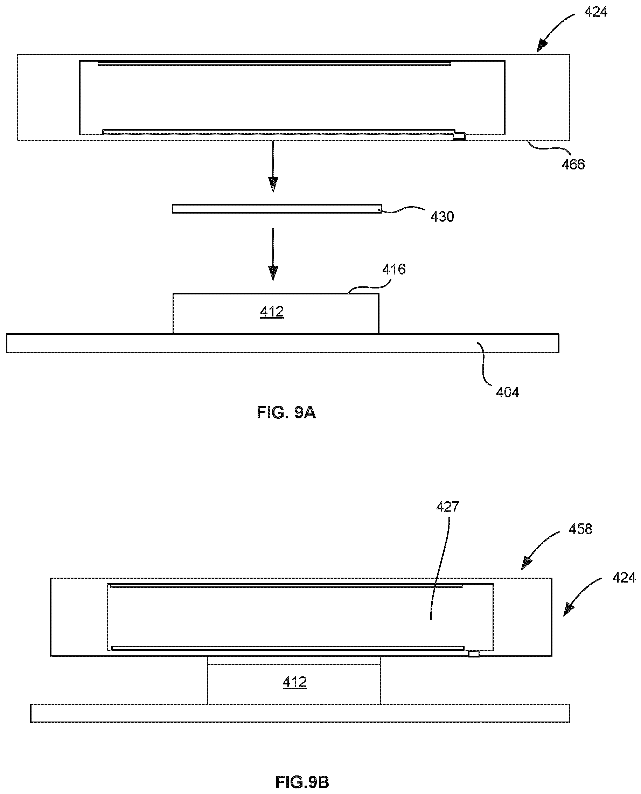

As in previous examples, FIGS. 9A-9D illustrate a method of assembling chip package system 400. As shown in FIG. 9A, vapor chamber 424 may be directly bonded to chip 412, which is electrically connected and coupled to substrate 404. In some examples, bottom surface 466 of vapor chamber 424 may be solder bonded to rear surface 416 of chip 412 through use of STIM 430.

FIG. 9B illustrates in-process unit 458 after vapor chamber 424 has been bonded to chip 412. At this stage, vapor chamber assembly 424 has no fluid within interior chamber 427 and is not hermetically sealed. Vapor chamber assembly 424 may instead be at atmospheric pressure.

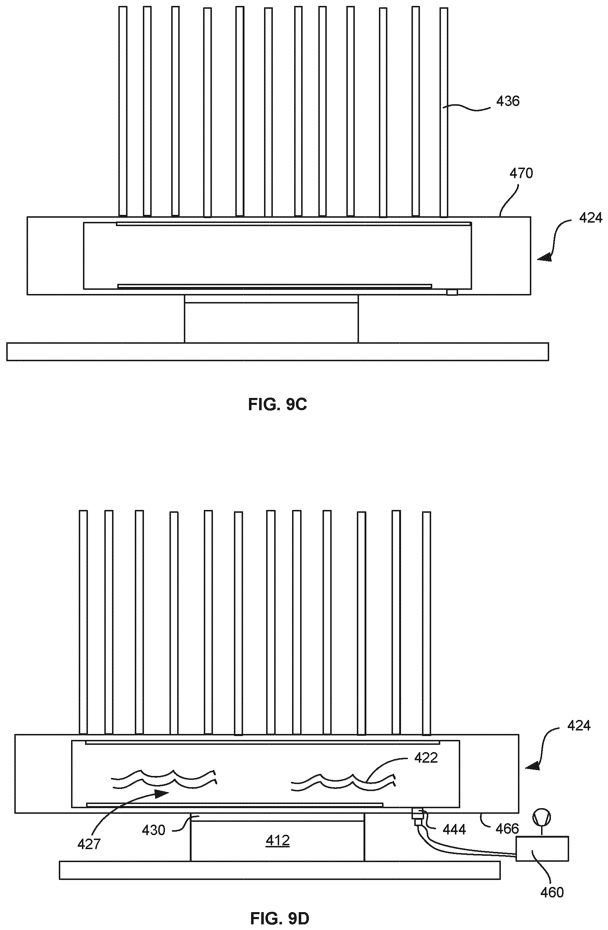

Fins 436 may be attached to top surface 470 of vapor chamber 424, as shown in FIG. 9C. Fins 436 may be soldered to top surface 470 using any known thermally conductive materials. In this example, fins 436 may be evenly-spaced apart from one another across top surface 470, but in other examples, the arrangement of fins 436 can differ. Additionally, fins 436 are schematically represented, but can take on many shapes and sizes.

As shown in FIG. 9D, fluid 422 may be introduced into interior chamber 427 through a port that provides access to interior chamber 427, such as port 444 positioned along bottom surface 466 of vapor chamber 424. Vacuum pump 460 may be further connected to vapor chamber 424 through port 444 to create a vacuum within interior chamber 427 and to allow for hermetic sealing of vapor chamber 424. Once vapor chamber 424 is hermetically sealed, vacuum pump 460 can be removed. By fully assembling and sealing vapor chamber 424 after at least a portion of vapor chamber 424 is first bonded to chip 412, STIM 430 with a melting point greater than or equal to 120 °C may be utilized in chip package system 400 to create a solder bond between vapor chamber 424 and rear surface 416 of chip 412. In other examples, STIM 430 may instead have a melting point less than 120 °C. Use of STIM 430 as described herein can provide for increased thermal conductivity of the material used to STIM and can help to reduce thermal resistance as compared to use of traditional grease or phase change material. In some examples, the reduction in thermal resistance may be approximately 50%.

According to an aspect of the disclosure, a method of manufacturing a chip package system that has at least one semiconductor chip overlying and attached to a substrate is disclosed. The method includes soldering a first portion of a vapor chamber to the at least one semiconductor chip using a solder thermal interface material; joining or attaching a second portion of the vapor chamber to the first portion to create an enclosed interior chamber within the vapor chamber; introducing a fluid into the interior chamber; and creating a vacuum within the interior chamber of the vapor chamber, wherein the soldering the first portion occurs prior to creating the vacuum; and/or
selecting the solder thermal interface material that comprises a melting point greater than at least 110 °C; and/or
selecting the solder thermal interface material that comprises a melting point greater than at least 120 °C; and/or
selecting the solder thermal interface material that comprises a melting point greater than at least 130 °C; and/or
selecting the solder thermal interface material that comprises a melting point greater than at least 140 °C; and/or
selecting the solder thermal interface material that comprises a melting point greater than at least 150 °C; and/or
selecting the solder thermal interface material that comprises a melting point greater than at least 160 °C; and/or
selecting the solder thermal interface material that comprises a melting point ranging from 110 °C to 180 °C; and/or
selecting the solder thermal interface material that comprises a melting point less than 110 °C; and/or
selecting the solder thermal interface material that comprises a melting point greater than 180 °C; and/or

forming a solder joint between the first portion and the at least one semiconductor chip using a combination of the solder thermal interface material and a flux material; and/or
the creating the vacuum occurs after the first and second portions are assembled together; and/or
   the attaching of the first portion and the second portion of the vapor chamber forms a main body of the vapor chamber, wherein the vapor chamber further comprises a top planar surface and a bottom planar surface, wherein the solder thermal interface material joins the bottom planar surface to the at least one semiconductor chip; and/or
   the attaching the second portion to the first portion comprises using a mechanical fastener to attach the second portion to the first portion; and/or
   the attaching the second portion to the first portion comprises using a bonding material to bond the second portion to the first portion; and/or
   the bonding material comprises a low temperature solder material; and/or
   receiving the first and second portions of the vapor chamber from a first vendor with a business location at a first geographic location, wherein the soldering the first portion of the vapor chamber, attaching the second portion of the vapor chamber, introducing the fluid into the interior chamber, and creating the vacuum with interior chamber are performed by a second vendor with a business location at a second geographic location; and/or
   forming a solder joint between the first portion and the at least one semiconductor chip using a combination of the solder thermal interface material and a flux material, wherein the solder thermal interface material comprises a melting point greater than at least 120 °C; and/or
   forming a solder joint between the first portion and the at least one semiconductor chip using a combination of the solder thermal interface material and a flux material, wherein the solder thermal interface material comprises a melting point greater than at least 110 °C; and/or bonding the semiconductor chip to the substrate; and/or
   the substrate is a printed circuit board; and/or
   the first portion further comprises a first wicking material extending along a surface of the first portion and a second wicking material extending along a surface of the second portion, the first and second wicking materials interact with the fluid within the interior chamber, and when attaching the first and second portions together, the first wicking material and the second wicking material face one another; and/or
   the solder thermal interface material comprises a foil further comprised of Indium, and wherein the method further comprises, applying the Indium foil to the vapor chamber or the at least one semiconductor chip, and then soldering the first portion to the at least one semiconductor chip; and/or
   applying the Indium foil to the vapor chamber and then soldering the vapor chamber to the at least one semiconductor chip; and/or
   applying the Indium foil to the at least one semiconductor chip and then soldering the vapor chamber to the at least one semiconductor chip; and/or
   the creating a vacuum further comprises attaching a vacuum pump assembly to a port of the vapor chamber and changing an interior pressure of the vapor chamber from atmospheric pressure to less than atmospheric pressure; and/or
   hermetically sealing the vapor chamber after soldering the first portion of the vapor chamber to the semiconductor chip; and/or
   the second portion of the vapor chamber further comprises heat pipes extending upwardly from the first portion and heat dissipation fins coupled to the heat pipes to further dissipate heat.

According to another aspect, a method of manufacturing a chip package system having at least one semiconductor chip overlying and attached to a substrate is disclosed. The method includes soldering a vapor chamber to the at least one semiconductor chip using a solder thermal interface material, the vapor chamber having an enclosed interior chamber within the vapor chamber; introducing a fluid into the interior chamber while the interior chamber is at atmospheric pressure; and creating a vacuum within the interior chamber of the vapor chamber by changing an interior pressure of the interior chamber from atmospheric pressure to less than atmospheric pressure, wherein the soldering occurs prior to creating the vacuum; and/or
hermetically sealing the vapor chamber after the creating the vacuum; and/or
attaching the vapor chamber to the substrate with a mechanical fastener, wherein the substrate is a printed circuit board; and/or
selecting the solder thermal interface material that comprises a melting point greater than at least 110 °C; and/or
selecting the solder thermal interface material that comprises a melting point greater than at least 120 °C; and/or
selecting the solder thermal interface material that comprises a melting point greater than at least 130 °C; and/or
selecting the solder thermal interface material that comprises a melting point greater than at least 140 °C; and/or
selecting the solder thermal interface material that comprises a melting point greater than at least 150 °C; and/or
selecting the solder thermal interface material that comprises a melting point greater than at least 160 °C; and/or
selecting the solder thermal interface material that comprises a melting point ranging from 110 °C to 180 °C; and/or
selecting the solder thermal interface material that comprises a melting point less than 110 °C; and/or
selecting the solder thermal interface material that comprises a melting point greater than 180 °C; and/or
the solder thermal interface material comprises a foil further comprised of Indium, and wherein the method further comprises, applying the Indium foil to the vapor chamber or the at least one semiconductor chip, and then soldering the vapor chamber to the at least one semiconductor chip; and/or
applying the Indium foil to the vapor chamber and then soldering the vapor chamber to the at least one semiconductor chip; and/or
applying the Indium foil to the at least one semiconductor chip and then soldering the vapor chamber to the at least one semiconductor chip; and/or
bonding the at least one semiconductor chip to the substrate with a solder ball array; and/or
the substrate is a printed circuit board and the bonding comprises bonding the at least one semiconductor chip to the printed circuit board; and/or.
the vapor chamber comprises a first portion and a second portion; and the method further comprises soldering a first portion of a vapor chamber to the at least one semiconductor chip with the solder thermal interface material; and attaching a second portion of the vapor chamber to the first portion to create the enclosed interior chamber within the vapor chamber. The soldering the first portion to the semiconductor chip occurs prior to creating the vacuum and/or.
forming a solder joint between the first portion and the at least one semiconductor chip using a combination of the solder thermal interface material and a flux material; and/or
the creating the vacuum occurs after the first and second portions are assembled together; and/or
the attaching the first portion and the second portion of the vapor chamber forms a main body of the vapor chamber, wherein the vapor chamber further comprises a top planar surface and a bottom planar surface, the solder thermal interface material joining the bottom planar surface to the at least one semiconductor chip; and/or
the attaching the second portion to the first portion comprises using a bonding material to solder the second portion to the first portion; and/or
the bonding material comprises a low temperature solder material; and/or
the attaching the second portion to the first portion comprises using a mechanical fastener to attach the second portion to the first portion; and/or
receiving the first and second portions of the vapor chamber from a first vendor with a business location at a first geographic location, wherein the soldering the first portion of the vapor chamber, attaching the second portion of the vapor chamber, introducing the fluid into the interior chamber, and creating the vacuum with interior chamber are performed by a second vendor with a business location at a second geographic location; and/or
the first portion further comprises a first wicking material extending along a surface of the first portion and a second wicking material extending along a surface of the second portion, wherein the first and second wicking materials interact with the fluid within the interior chamber, and wherein when attaching the first and second portions together, the first wicking material and the second wicking material face one another; and/or
the second portion of the vapor chamber further comprises heat pipes extending upwardly from the first portion and heat dissipation fins coupled to the heat pipes to further dissipate heat; and/or
the solder thermal interface material comprises a foil further comprised of Indium, and wherein the method further comprises, applying the Indium foil to the vapor chamber or the at least one semiconductor chip, and then soldering the first portion to the at least one semiconductor chip; and/or
hermetically sealing the vapor chamber after soldering the first portion of the vapor chamber to the semiconductor chip.

According to another aspect, a microelectronic package system includes a substrate; a semiconductor chip bonded to the substrate; a hermetically sealed vapor chamber soldered to and in thermal communication with the semiconductor chip; and a solder thermal interface material joint formed between the vapor chamber and the semiconductor chip. The solder thermal interface material comprising the solder thermal interface joint comprises an interface material having a melting point greater than 120 °C; and/or
the solder joint further comprises a flux material; and/or
a wicking material is disposed within the hermetically sealed vapor chamber.

According to another aspect of the disclosure, an in-process unit for a chip package system includes a substrate; a semiconductor chip bonded to the substrate; and a portion of a vapor chamber soldered to and in thermal communication with the semiconductor chip. A solder joint is formed between the vapor chamber and the semiconductor chip and the solder joint comprises a solder material; and/or
the solder joint further comprises a flux material; and/or
a wicking material is disposed within a recess of the vapor chamber and the wicking material is exposed; and/or
selecting the solder thermal interface material that comprises a material having a melting point greater than at least 120 °C; and/or
selecting the solder thermal interface material that comprises a melting point greater than at least 110 °C; and/or
selecting the solder thermal interface material that comprises a melting point greater than at least 120 °C; and/or
selecting the solder thermal interface material that comprises a melting point greater than at least 130 °C; and/or
selecting the solder thermal interface material that comprises a melting point greater than at least 140 °C; and/or
selecting the solder thermal interface material that comprises a melting point greater than at least 150 °C; and/or
selecting the solder thermal interface material that comprises a melting point greater than at least 160 °C; and/or
selecting the solder thermal interface material that comprises a melting point ranging from 110 °C to 180 °C; and/or
selecting the solder thermal interface material that comprises a melting point less than 110 °C; and/or
selecting the solder thermal interface material that comprises a melting point greater than 180 °C; and/or
attaching the vapor chamber to the substrate with a mechanical fastener, wherein the substrate is a printed circuit board; and/or
the second portion of the vapor chamber further comprises heat pipes extending upwardly from the first portion and heat dissipation fins coupled to the heat pipes to further dissipate heat.

Unless otherwise stated, the foregoing alternative examples are not mutually exclusive, but may be implemented in various combinations to achieve unique advantages. **In** addition, the provision of the examples described herein, as well as clauses phrased as "such as," "including," and the like, should not be interpreted as limiting the subject matter of the claims to the specific examples; rather, the examples are intended to illustrate only one of many possible implementations. Further, although reference was made to vendors or contract manufacturers, such vendors can include any entity involved with manufacture and/or assembly of one or more components in the systems. Additionally, although components of the systems and assemblies described herein may be described as being assembled and/or forwarded by a first vendor, it is to be appreciated that additional vendors may provide the components necessary for assembling the chip package system and/or additional vendors may assemble different components of the chip packaging system, which are then forwarded to a final vendor for final assembly. Further, the same or similar reference numbers in different drawings can identify the same or similar elements. Further, the figures schematically represent components of vapor chamber assemblies and chip package assemblies and systems necessary to aid the discussion. However, it is to be appreciated that there may be additional details or components that are omitted but are not required for an understanding of the disclosed features and would be understood by one of skill in the art to be present in the disclosed assembly, package, and/or system.

## Claims

1. A method of manufacturing a chip package system (100) having at least one semiconductor chip (112) overlying and attached to a substrate (104), the method comprising:
soldering a vapor chamber (124) to the at least one semiconductor chip using a solder thermal interface material (130), the vapor chamber having an enclosed interior chamber (127) within the vapor chamber;
introducing a fluid (122) into the interior chamber while the interior chamber is at atmospheric pressure; and
creating a vacuum within the interior chamber of the vapor chamber by changing an interior pressure of the interior chamber from atmospheric pressure to less than atmospheric pressure,
wherein the soldering occurs prior to creating the vacuum.

2. The method of claim 1, further comprising hermetically sealing the vapor chamber (124) after the creating the vacuum.

3. The method of any one of claims 1-2, further comprising selecting the solder thermal interface material (130) having a melting point greater than at least 110 °C; or selecting the solder thermal interface material having a melting point greater than at least 120 °C.

4. The method of any one of claims 1-3, wherein the solder thermal interface material (130) comprises a foil further comprised of Indium, and wherein the method further comprises, applying the Indium foil to the vapor chamber (124) or the at least one semiconductor chip (112), and then soldering the vapor chamber to the at least one semiconductor chip.

5. The method of any one of claims 1-4, wherein the vapor chamber (124) comprises a first portion (126) and a second portion (128), and the method further comprises:
soldering the first portion of the vapor chamber to the at least one semiconductor chip (112) with the solder thermal interface material (130); and
attaching the second portion of the vapor chamber to the first portion to create the enclosed interior chamber (127) within the vapor chamber,
wherein the soldering the first portion to the semiconductor chip occurs prior to creating the vacuum.

6. The method of claim 5, further comprising forming a solder joint between the first portion (126) and the at least one semiconductor chip (112) using a combination of the solder thermal interface material (130) and a flux material.

7. The method of any one of claims 5-6, wherein the creating the vacuum occurs after the first and second portions (126, 128) are assembled together.

8. The method of any one of claims 5-7, wherein the attaching the first portion (126) and the second portion (128) of the vapor chamber (124) forms a main body of the vapor chamber, wherein the vapor chamber further comprises a top planar surface and a bottom planar surface, the solder thermal interface material (130) joining the bottom planar surface to the at least one semiconductor chip (112).

9. The method of any one of claims 5-8, wherein the attaching the second portion (128) to the first portion (126) comprises using a bonding material (262) to solder the second portion to the first portion; and/or
the bonding material comprises a low temperature solder material; and/or
the attaching the second portion to the first portion comprises using a mechanical fastener (140) to attach the second portion to the first portion.

10. The method of any one of claims 5-9, wherein the first portion (126) further comprises a first wicking material (132) extending along a surface of the first portion and a second wicking material (132) extending along a surface of the second portion, wherein the first and second wicking materials interact with the fluid (122) within the interior chamber (127), and wherein when attaching the first and second portions together, the first wicking material and the second wicking material face one another; and/or
wherein the second portion (128) of the vapor chamber (124) further comprises heat pipes (134) extending upwardly from the first portion and heat dissipation fins (136) coupled to the heat pipes to further dissipate heat.

11. The method of any one of claims 5-10, wherein the solder thermal interface material (130) comprises a foil further comprised of Indium, and wherein the method further comprises, applying the Indium foil to the vapor chamber (124) or the at least one semiconductor chip (112), and then soldering the first portion (126) to the at least one semiconductor chip.

12. The method of any one of claims 5-11, further comprising hermetically sealing the vapor chamber (124) after soldering the first portion (126) of the vapor chamber to the semiconductor chip (112).

13. A microelectronic package system (100) comprising:
a substrate (104);
a semiconductor chip (112) bonded to the substrate;
a hermetically sealed vapor chamber (124) soldered to and in thermal communication with the semiconductor chip (112), wherein the vacuum chamber is soldered to the semiconductor chip prior to creating a vacuum within the vacuum chamber; and
a solder thermal interface material joint formed between the vapor chamber and the semiconductor chip,
wherein the solder thermal interface material (130) comprising the solder thermal interface joint comprises an interface material having a melting point greater than 120 °C.

14. The system of claim 13, wherein the solder thermal interface material joint further comprises a flux material; and/or
a wicking material (132) is disposed within the hermetically sealed vapor chamber (124).

## Patentansprüche

1. Verfahren zur Herstellung eines Chipgehäusesystems (100), das mindestens einen über einem Substrat (104) liegenden und daran befestigten Halbleiterchip (112) aufweist, wobei das Verfahren Folgendes umfasst:
Löten einer Dampfkammer (124) an den mindestens einen Halbleiterchip unter Verwendung eines Lötwärmeschnittstellenmaterials (130), wobei die Dampfkammer eine umschlossene Innenkammer (127) innerhalb der Dampfkammer aufweist;
Einbringen eines Fluids (122) in die Innenkammer, während die Innenkammer unter Atmosphärendruck steht; und
Erzeugen eines Vakuums innerhalb der Innenkammer der Dampfkammer durch Ändern eines Innendrucks der Innenkammer von Atmosphärendruck auf weniger als Atmosphärendruck,
wobei das Löten vor dem Erzeugen des Vakuums erfolgt.

2. Verfahren nach Anspruch 1, ferner umfassend hermetisches Abdichten der Dampfkammer (124) nach dem Erzeugen des Vakuums.

3. Verfahren nach einem der Ansprüche 1-2, ferner umfassend Auswählen des Lötwärmeschnittstellenmaterials (130), das einen Schmelzpunkt von mehr als mindestens 110 °C aufweist; oder Auswählen des Lötwärmeschnittstellenmaterials, das einen Schmelzpunkt von mehr als mindestens 120 °C aufweist.

4. Verfahren nach einem der Ansprüche 1-3, wobei das Lötwärmeschnittstellenmaterial (130) eine Folie umfasst, die ferner Indium umfasst, und wobei das Verfahren ferner Aufbringen der Indiumfolie auf die Dampfkammer (124) oder den mindestens einen Halbleiterchip (112) und dann Löten der Dampfkammer an den mindestens einen Halbleiterchip umfasst.

5. Verfahren nach einem der Ansprüche 1-4, wobei die Dampfkammer (124) einen ersten Abschnitt (126) und einen zweiten Abschnitt (128) umfasst und das Verfahren ferner Folgendes umfasst:
Löten des ersten Abschnitts der Dampfkammer an den mindestens einen Halbleiterchip (112) mit dem Lötwärmeschnittstellenmaterial (130); und
Befestigen des zweiten Abschnitts der Dampfkammer am ersten Abschnitt, um die umschlossene Innenkammer (127) innerhalb der Dampfkammer zu erzeugen,
wobei das Löten des ersten Abschnitts an den Halbleiterchip vor dem Erzeugen des Vakuums erfolgt.

6. Verfahren nach Anspruch 5, ferner umfassend Ausbilden einer Lötverbindungsstelle zwischen dem ersten Abschnitt (126) und dem mindestens einen Halbleiterchip (112) unter Verwendung einer Kombination aus dem Lötwärmeschnittstellenmaterial (130) und einem Flussmittelmaterial.

7. Verfahren nach einem der Ansprüche 5-6, wobei das Erzeugen des Vakuums erfolgt, nachdem der erste und der zweite Abschnitt (126, 128) zusammengebaut worden sind.

8. Verfahren nach einem der Ansprüche 5-7, wobei das Befestigen des ersten Abschnitts (126) und des zweiten Abschnitts (128) der Dampfkammer (124) einen Hauptkörper der Dampfkammer ausbildet, wobei die Dampfkammer ferner eine obere ebene Oberfläche und eine untere ebene Oberfläche umfasst, wobei das Lötwärmeschnittstellenmaterial (130) die untere ebene Oberfläche mit dem mindestens einen Halbleiterchip (112) verbindet.

9. Verfahren nach einem der Ansprüche 5-8, wobei das Befestigen des zweiten Abschnitts (128) am ersten Abschnitt (126) Verwenden eines Bondmaterials (262) zum Löten des zweiten Abschnitts an den ersten Abschnitt umfasst; und/oder das Bondmaterial ein Niedertemperatur-Lötmaterial umfasst; und/oder
das Befestigen des zweiten Abschnitts am ersten Abschnitt Verwenden eines mechanischen Befestigungselements (140) zum Befestigen des zweiten Abschnitts am ersten Abschnitt umfasst.

10. Verfahren nach einem der Ansprüche 5-9, wobei der erste Abschnitt (126) ferner ein sich entlang einer Oberfläche des ersten Abschnitts erstreckendes erstes Dochtmaterial (132) und ein sich entlang einer Oberfläche des zweiten Abschnitts erstreckendes zweites Dochtmaterial (132) umfasst, wobei das erste und das zweite Dochtmaterial mit dem Fluid (122) innerhalb der Innenkammer (127) interagieren und wobei beim Befestigen des ersten und des zweiten Abschnitts aneinander das erste Dochtmaterial und das zweite Dochtmaterial einander zugewandt sind; und/oder
wobei der zweite Abschnitt (128) der Dampfkammer (124) ferner sich vom ersten Abschnitt nach oben erstreckende Wärmerohre (134) und mit den Wärmerohren gekoppelte Wärmeableitrippen (136) zum weiteren Ableiten von Wärme umfasst.

11. Verfahren nach einem der Ansprüche 5-10, wobei das Lötwärmeschnittstellenmaterial (130) eine Folie umfasst, die ferner Indium umfasst, und wobei das Verfahren ferner Aufbringen der Indiumfolie auf die Dampfkammer (124) oder den mindestens einen Halbleiterchip (112) und dann Löten des ersten Abschnitts (126) an den mindestens einen Halbleiterchip umfasst.

12. Verfahren nach einem der Ansprüche 5-11, ferner umfassend hermetisches Abdichten der Dampfkammer (124) nach dem Löten des ersten Abschnitts (126) der Dampfkammer an den Halbleiterchip (112).

13. Mikroelektronisches Gehäusesystem (100), umfassend:
ein Substrat (104);
einen auf das Substrat gebondeten Halbleiterchip (112);
eine hermetisch abgedichtete, an den Halbleiterchip (112) gelötete und mit diesem in Wärmekontakt stehende Dampfkammer (124), wobei die Vakuumkammer vor Erzeugen eines Vakuums innerhalb der Vakuumkammer an den Halbleiterchip gelötet wird; und
eine zwischen der Dampfkammer und dem Halbleiterchip ausgebildete Lötwärmeschnittstellenmaterial-Verbindungsstelle, wobei das die Lötwärmeschnittstellen-Verbindungsstelle umfassende Lötwärmeschnittstellenmaterial (130) ein Schnittstellenmaterial umfasst, das einen Schmelzpunkt von mehr als 120 °C aufweist.

14. System nach Anspruch 13, wobei die Lötwärmeschnittstellenmaterial-Verbindungsstelle ferner ein Flussmittelmaterial umfasst; und/oder
ein Dochtmaterial (132) innerhalb der hermetisch abgedichteten Dampfkammer (124) angeordnet ist.

## Revendications

1. Procédé de fabrication d'un système de boîtier de puce (100) ayant au moins une puce semi-conductrice (112) recouvrant et fixée à un substrat (104), le procédé comprenant :
la soudure d'une chambre à vapeur (124) à l'au moins une puce semi-conductrice à l'aide d'un matériau d'interface thermique de soudure (130), la chambre à vapeur ayant une chambre intérieure fermée (127) à l'intérieur de la chambre à vapeur ; l'introduction d'un fluide (122) dans la chambre intérieure alors que la chambre intérieure est à pression atmosphérique ; et
la création d'un vide à l'intérieur de la chambre intérieure de la chambre à vapeur en faisant passer une pression intérieure de la chambre intérieure de la pression atmosphérique à une pression inférieure à la pression atmosphérique,
dans lequel la soudure a lieu avant la création du vide.

2. Procédé selon la revendication 1, comprenant en outre le scellement hermétique de la chambre à vapeur (124) après la création du vide.

3. Procédé selon l'une quelconque des revendications 1 et 2, comprenant en outre la sélection du matériau d'interface thermique de soudure (130) ayant un point de fusion supérieur à au moins 110 °C ; ou la sélection du matériau d'interface thermique de soudure ayant un point de fusion supérieur à au moins 120 °C.

4. Procédé selon l'une quelconque des revendications 1 à 3, dans lequel le matériau d'interface thermique de soudure (130) comprend une feuille en outre constituée d'indium, et dans lequel le procédé comprend en outre l'application de la feuille d'indium à la chambre à vapeur (124) ou à l'au moins une puce semi-conductrice (112), puis la soudure de la chambre à vapeur à l'au moins une puce semi-conductrice.

5. Procédé selon l'une quelconque des revendications 1 à 4, dans lequel la chambre à vapeur (124) comprend une première partie (126) et une seconde partie (128), et le procédé comprend en outre :
la soudure de la première partie de la chambre à vapeur à l'au moins une puce semi-conductrice (112) avec le matériau d'interface thermique de soudure (130) ; et
la fixation de la seconde partie de la chambre à vapeur à la première partie pour créer la chambre intérieure fermée (127) à l'intérieur de la chambre à vapeur,
dans lequel la soudure de la première partie à la puce semi-conductrice a lieu avant la création du vide.

6. Procédé selon la revendication 5, comprenant en outre la formation d'un joint de soudure entre la première partie (126) et l'au moins une puce semi-conductrice (112) à l'aide d'une combinaison du matériau d'interface thermique de soudure (130) et d'un matériau de flux.

7. Procédé selon l'une quelconque des revendications 5 et 6, dans lequel la création du vide a lieu après que les première et seconde parties (126, 128) sont assemblées ensemble.

8. Procédé selon l'une quelconque des revendications 5 à 7, dans lequel la fixation de la première partie (126) et de la seconde partie (128) de la chambre à vapeur (124) forme un corps principal de la chambre à vapeur, dans lequel la chambre à vapeur comprend en outre une surface plane supérieure et une surface plane inférieure, le matériau d'interface thermique de soudure (130) reliant la surface plane inférieure à l'au moins une puce semi-conductrice (112).

9. Procédé selon l'une quelconque des revendications 5 à 8, dans lequel la fixation de la seconde partie (128) à la première partie (126) comprend l'utilisation d'un matériau de liaison (262) pour souder la seconde partie à la première partie ; et/ou le matériau de liaison comprend un matériau de soudure à basse température ; et/ou
la fixation de la seconde partie à la première partie comprend l'utilisation d'un élément de fixation mécanique (140) pour fixer la seconde partie à la première partie.

10. Procédé selon l'une quelconque des revendications 5 à 9, dans lequel la première partie (126) comprend en outre un premier matériau de mèche (132) s'étendant le long d'une surface de la première partie et un second matériau de mèche (132) s'étendant le long d'une surface de la seconde partie, dans lequel les premier et second matériaux de mèche interagissent avec le fluide (122) à l'intérieur de la chambre intérieure (127), et dans lequel, lors de la fixation des première et seconde parties ensemble, le premier matériau de mèche et le second matériau de mèche se font face ; et/ou
dans lequel la seconde partie (128) de la chambre à vapeur (124) comprend en outre des caloducs (134) s'étendant vers le haut à partir de la première partie et des ailettes de dissipation de chaleur (136) couplées aux caloducs pour dissiper davantage la chaleur.

11. Procédé selon l'une quelconque des revendications 5 à 10, dans lequel le matériau d'interface thermique de soudure (130) comprend une feuille en outre constituée d'indium, et dans lequel le procédé comprend en outre l'application de la feuille d'indium à la chambre à vapeur (124) ou à l'au moins une puce semi-conductrice (112), puis la soudure de la première partie (126) à l'au moins une puce semi-conductrice.

12. Procédé selon l'une quelconque des revendications 5 à 11, comprenant en outre le scellement hermétique de la chambre à vapeur (124) après la soudure de la première partie (126) de la chambre à vapeur à la puce semi-conductrice (112).

13. Système de boîtier microélectronique (100) comprenant :
un substrat (104) ;
une puce semi-conductrice (112) liée au substrat ;
une chambre à vapeur hermétiquement scellée (124) soudée à et en communication thermique avec la puce semi-conductrice (112) , dans lequel la chambre à vide est soudée à la puce semi-conductrice avant la création d'un vide à l'intérieur de la chambre à vide ; et
un joint de matériau d'interface thermique de soudure formé entre la chambre à vapeur et la puce semi-conductrice,
dans lequel le matériau d'interface thermique de soudure (130) comprenant le joint d'interface thermique de soudure comprend un matériau d'interface ayant un point de fusion supérieur à 120 °C.

14. Système selon la revendication 13, dans lequel le joint de matériau d'interface thermique de soudure comprend en outre un matériau de flux ; et/ou
un matériau de mèche (132) est disposé à l'intérieur de la chambre à vapeur hermétiquement scellée (124).
